Europäisches Patentamt

European Patent Office

Office européen des brevets

(19)

(11) Numéro de publication: **0 123 625**
**A1**

## (12) DEMANDE DE BREVET EUROPEEN

(21) Numéro de dépôt: **84400821.9**

(22) Date de dépôt: **20.04.84**

(51) Int. Cl.³: **H 05 K 5/06**
**B 29 C 6/00**

(30) Priorité: **21.04.83 FR 8306568**

(43) Date de publication de la demande:
**31.10.84 Bulletin 84/44**

(84) Etats contractants désignés:
**BE DE FR GB IT NL**

(71) Demandeur: **EUROFARAD EFD**
**93 rue Oberkampf**
**F-75011 Paris(FR)**

(72) Inventeur: **Massiot, Michel**
**15, avenue Parmentier**
**F-75011 Paris(FR)**

(72) Inventeur: **Marchand, Daniel**
**25, rue Léon Frot**
**F-75011 Paris(FR)**

(74) Mandataire: **Martin, Jean-Jacques et al,**
**Cabinet REGIMBEAU 26, Avenue Kléber**
**F-75116 Paris(FR)**

(54) Composant surmoulé muni d'inserts métalliques de fixation, et procédé pour sa fabrication.

(57) Le composant (10) électrique ou électronique est surmoulé dans un bloc (20) de résine souple ou semidure telle qu'une résine silicone ou époxy.

Pour permettre la fixation du bloc surmoulé à un support (40), des inserts métalliques (30) sont surmoulés en même temps que le composant.

Selon l'invention, chaque insert est lui-même emprisonné dans un bloc (60) en résine dure telle qu'une résine époxy.

L'insert métallique est ainsi rigidement solidarisé au bloc de résine souple; les tendances à l'arrachement et à la rotation de l'insert sont considérablement minimisées, ainsi que les conséquences des cycles thermiques que doit pouvoir subir le composant.

En outre, la partie inférieure du bloc (20) de résine souple, chargée par des entretoises (70a-70c) reliant les blocs (60) de résine dure, présente un coefficient de dilatation réduit, du même ordre de grandeur que celui du support métallique (40).

Application au surmoulage de composants tels que transformateurs ou condensateurs, notamment pour les matériels aéronautiques.

FIG.4

EP 0 123 625 A1

Croydon Printing Company Ltd.

# COMPOSANT SURMOULE MUNI D'INSERTS METALLIQUES DE FIXATION, ET PROCEDE POUR SA FABRICATION

La présente invention concerne un composant surmoulé muni d'inserts métalliques de fixation, ainsi qu'un procédé pour sa fabrication.

De nombreux composants sont surmoulés, c'est-à-dire qu'ils sont soumis à une inclusion dans un bloc de résine synthétique assurant leur protection contre les agressions extérieures, qu'elles soient mécaniques, thermiques ou chimiques.

Ici et dans la suite, on entendra par "surmoulage" l'inclusion dans un bloc obtenu par coulage (ou autre procédé) d'une résine thermodurcissable, excluant donc les procédés de moulage par injection ou soufflage de matériaux thermoformables.

On assimilera au cas du composant surmoulé (inclusion a posteriori) celui du composant moulé, c'est-à-dire dont le bloc de résine fait partie intégrante de la structure.

Les résines utilisées sont classiquement des résines époxy, des résines polyuréthane, des silicones ou des résines analogues. En particulier, lorsque le composant doit résister à des contraintes thermiques et mécaniques importantes (cycles thermiques, vibrations,...) ces conditions imposent le choix d'une résine dite "souple" ou "semi-dure", une résine "dure" étant inacceptable en raison de sa tendance à la fissuration, notamment sous l'effet de la dilatation du composant qui est inclus à l'intérieur. Au contraire, une résine souple ou semi- dure absorbe parfaitement ces effets et permet au bloc de conserver sa cohérence et ses qualités (ici et dans la suite, on entendra par "résine dure" une résine dont la dureté est au moins égale à 80 Shore D, une résine de dureté inférieure à cette valeur étant qualifiée de "souple" ou "semi-dure").

Par ailleurs, lorsque les dimensions du composant deviennent importantes (transformateur, condensateur de forte valeur, ....), il est prévu des inserts métalliques ou "prisonniers de fixation" surmoulés dans le bloc de résine en même temps que le composant et permettant la fixation de l'ensemble à un support extérieur. Ces inserts ont par exemple la forme d'écrous métalliques affleurant une surface du bloc surmoulé et destinés à recevoir des vis de fixation permettant le serrage du bloc surmoulé contre le support.

Malheureusement, ces inserts métalliques, qui sont donc rigides, ont tendance à s'arracher facilement lorsqu'ils sont inclus dans une résine souple ou semi-dure. En particulier, au moment du serrage du bloc contre son support, l'insert a tendance à tourner dans la matière souple ou semi-dure, ce qui dégrade la tenue mécanique de l'ensemble (qui est d'autant plus nécessaire que le composant est lourd et volumineux et que les vibrations sont intenses).

Pour réduire cette tendance à tourner, on a alors cherché à donner à l'insert une forme plus anguleuse, par exemple la forme polygonale d'un écrou à 4 ou 6 pans. Cette forme, qui améliore la tenue mécanique, a cependant pour inconvénient de moins bien résister aux cycles thermiques, et ce d'autant plus qu'elle s'éloigne de la forme arrondie, qui est la forme optimale du point de vue de la minimisation des contraintes thermiques et électriques (le champ électrique s'accroît en effet au voisinage d'une pièce métallique anguleuse). La remarque vaut également lorsque l'on cherche à augmenter les dimensions de l'insert pour lui procurer un meilleur ancrage dans le bloc de résine ; en outre, dans ce cas, un problème de place se pose très rapidement, le composant surmoulé étant déjà par lui-même très volumineux puisqu'il faut prévoir des inserts rapportés pour la fixation du bloc. On mentionnera également les risques électriques que peut créer une pièce métallique de trop grande taille.

Les inserts de fixation actuellement utilisés pour la fixation des composants surmoulés dans un bloc de résine souple ou semi-dure ont donc une forme intermédiaire entre celle qui assure la meilleure tenue en température (forme la plus arrondie) et celle assurant la meilleure tenue mécanique (forme la plus anguleuse et dimensions importantes pour réduire la tendance à la rotation dans le bloc et à l'arrachement hors du bloc).

Par ailleurs, dans le cas de composants soumis à des cycles thermiques répétés et de forte amplitude (par exemple dans le cas de matériels aéronautiques embarqués), des contraintes mécaniques importantes naissent en raison des coefficients de dilatation très différents (typiquement dans un rapport de 1 à 10) pour une résine souple et pour un support métallique . Ces contraintes peuvent amener à terme les inserts à se détacher du bloc, et c'est pourquoi l'on se contente généralement d'utiliser des résines assez dures, à plus faible coefficient de dilatation, malgré leur fragilité et leur efficacité médiocre en ce qui concerne l'absorption des vibrations et des chocs.

Un des buts de l'invention est de s'affranchir de ces solutions de compromis, en assurant un maintien rigide de l'insert métallique dans le bloc tout en permettant le surmoulage dans une résine aussi souple qu'il est nécessaire.

Pour cela, l'invention propose que chaque insert soit lui-même emprisonné dans un bloc en résine dure, ce dernier étant surmoulé avec le composant dans le bloc de résine souple ou semi-dure.

De cette manière, l'insert métallique est rigidement maintenu dans le bloc de résine dure, ce qui permet de donner à l'insert une forme peu agressive du point de vue des contraintes thermiques, proche de la forme arrondie idéale.

Ainsi, avantageusement, l'insert métallique peut comprendre, au moins sur une partie de sa hauteur, une partie de section polygonale, dont les arêtes sont de préférence abattues.

Le bloc prémoulé peut ensuite être surmoulé dans une résine aussi souple qu'il est souhaité, l'accrochage des deux résines étant obtenu sans difficulté : d'une part, les deux résines sont des matériaux voisins, ayant des coefficients de dilatation du même ordre et qui présentent d'excellentes propriétés d'adhérence réciproque ; d'autre part, la surface commune de contact à l'interface des deux résines (c'est-à-dire la surface du bloc prémoulé) est très supérieure à celle du simple insert, ce qui augmente d'autant la tenue à l'arrachement. De cette manière, il est possible de donner au bloc prémoulé une forme cylindrique, sensiblement coaxiale avec l'insert métallique qui y est emprisonné ; cette forme est la plus facile à réaliser et correspond à un encombrement réduit au minimum.

Pour augmenter la surface commune de contact, on peut donner au bloc en résine dure une hauteur supérieure à celle de l'insert métallique, de préférence une hauteur au moins double de la hauteur de celui-ci.

Avantageusement, le composant comprend une pluralité d'inserts emprisonnés chacun dans un bloc respectif en résine dure, et certains au moins des blocs de résine sont solidarisés ensemble par au moins une entretoise rigide.

De préférence, le matériau constituant les entretoises rigides est une résine époxy chargée de fibres de verre, et les entretoises et les blocs de résine dure sont assemblés ensemble par collage au moyen d'une colle époxy.

Cette structure permet de charger la partie inférieure du composant surmoulé en lui donnant un coefficient de dilatation (de l'ordre de 10-20 ppm/°C) voisin de celui de la plaque métallique sur laquelle il est fixé (de l'ordre de 15 à 25 ppm/°C), et très inférieur à celui de la résine souple d'enrobage dans la partie non chargée du composant (de l'ordre de 100 à 200 ppm/°C). On évite ainsi des contraintes thermiques au droit des fixations, l'entraxe des inserts du composant restant toujours à peu près égal à l'entraxe des trous de fixation de la plaque métallique.

Le procédé de fabrication comprend une étape de prémoulage de chaque insert dans un bloc de résine dure, cette étape étant suivie de l'étape classique de surmoulage, par coulage d'un bloc de résine souple ou semi-dure noyant le composant et les inserts emprisonnés dans leur bloc de résine dure.

Lorsque l'une et l'autre résine sont des résines époxy, il est avantageux de prévoir, après prémoulage de l'insert mais avant surmoulage, une étape de gélification du bloc prémoulé, le durcissement final de ce dernier étant réalisé en même temps que celui du bloc surmoulé.

Lorsque la résine souple ou semi-dure est une résine silicone et la résine dure est une résine époxy, on prévoit de préférence, après prémoulage de l'insert et durcissement de la résine dure, mais avant surmoulage, une étape d'application d'un enduit primaire d'adhérence ("primer") sur l'insert prémoulé.

D'autres caractéristiques et avantages de l'invention apparaîtront à la lecture de la description détaillée ci-dessous, faite en référence aux dessins annexés, sur lesquels :

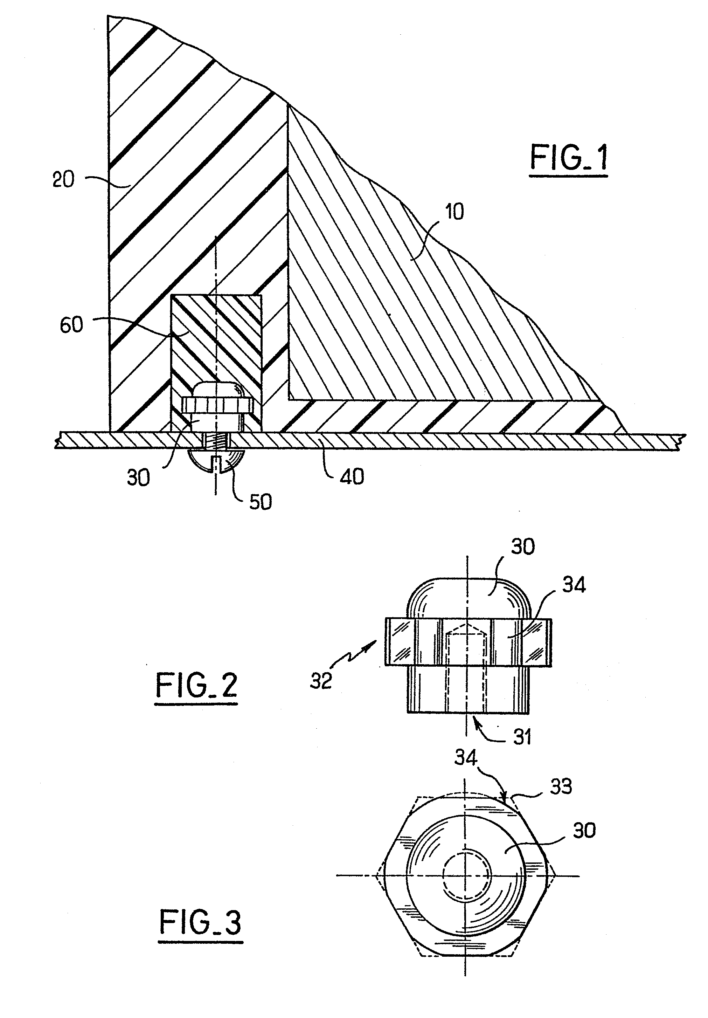

. la figure 1 est une vue en coupe d'une partie d'un composant surmoulé selon l'invention, fixé sur un support,

. les figures 2 et 3 sont des vues, respectivement en élévation et en plan d'un exemple d'insert métallique de fixation.

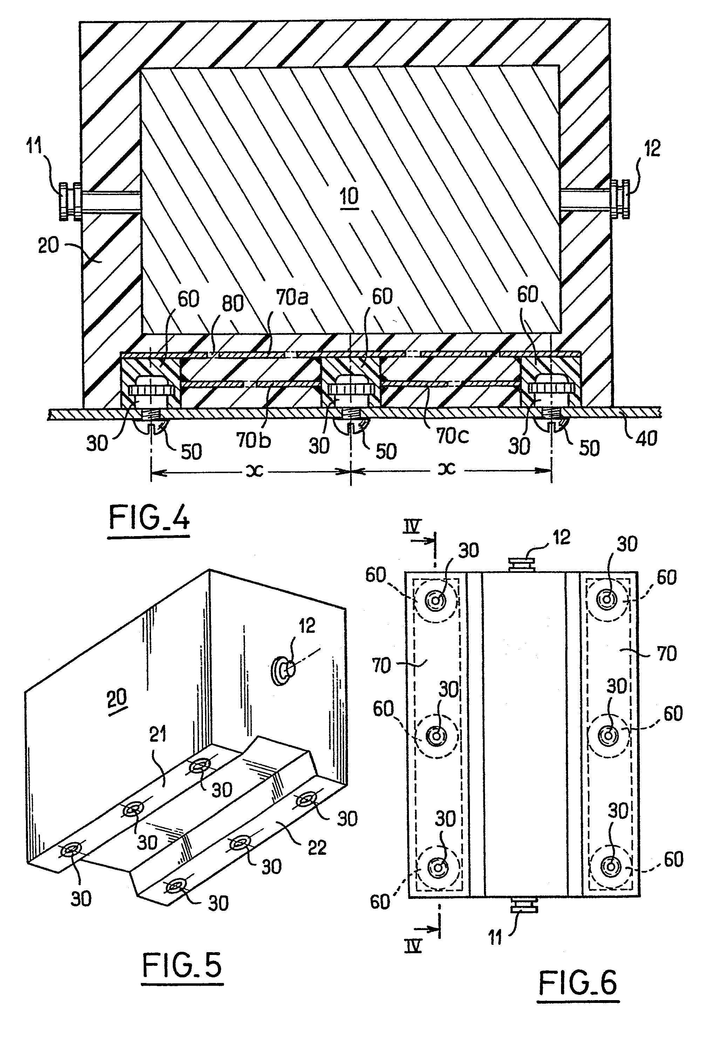

. la figure 4 est une vue en coupe (selon la ligne IV-IV de la figure 6) d'un composant complet dans lequel la partie inférieure est chargée par des barrettes réunissant les blocs de résine dure individuels emprisonnant les inserts.

. les figures 5 et 6 sont des vues de dessous de ce même composant, respectivement en perspective et en plan.

Sur la figure 1, le composant référencé 10, qui peut être un transformateur, un condensateur volumineux, ... est enrobé dans un bloc surmoulé 20. Le bloc 20 est muni d'inserts métalliques 30, dont un a été représenté, qui permettent sa fixation à un support 40, par exemple au moyen de vis de fixation 50 introduites dans un orifice fileté homologue de l'insert métallique 30.

Selon l'invention, l'insert métallique 30 est noyé dans un bloc prémoulé en résine dure, par exemple cylindrique et coaxial à l'insert, qui assure l'accrochage de ce dernier dans le bloc surmoulé 20 en résine souple ou semi-dure.

La hauteur du bloc prémoulé 60 peut être supérieure à celle de l'insert pour obtenir une meilleure adhérence par accroissement de la surface de l'interface entre les deux résines.

Les figures 2 et 3 montrent un exemple d'insert métallique 30 utilisable dans la structure de l'invention : il a la forme d'un écrou borgne muni d'un trou fileté 31 et comportant une zone 32 de section polygonale (par exemple à 6 pans). Pour réduire les contraintes thermiques exercées sur le bloc surmoulé, les arêtes 33 de la partie polygonale sont abattues, par exemple par un passage au tour, ce qui les transforme en surface arrondie 34.

Le métal constituant l'écrou est choisi en fonction des conditions climatiques, du type de vis,..., indépendamment des types de résines employées pour le prémoulage et le surmoulage.

On décrira maintenant deux exemples de procédés selon l'invention, l'un dans lequel la résine de surmoulage est une résine silicone, l'autre dans lequel cette résine est une résine époxy.

Exemple I

Chacun des inserts métalliques est tout d'abord prémoulé dans un bloc de résine dure. Cette résine est par exemple une résine DGEBA (diglycidiléther de bisphénol A), avec un durcisseur par exemple anhydride du type HHPA (anhydride hexahydrophtalique) et un accélérateur tel qu'un BDMA (amine benzyldiméthyl).

Cette résine dure est fortement chargée par des fibres longues (fibres minérales telles que des fibres de verre par exemple), une charge non fibreuse supplémentaire pouvant éventuellement être prévue. Cette charge de la résine permet d'emprisonner fermement l'insert et diminue les risques de fissuration, inhérents à une résine dure.

Pour améliorer l'accrochage ultérieur avec la résine de surmoulage, l'insert prémoulé n'est pas polymérisé complètement, mais seulement gélifié, par exemple par passage à une température d'environ 60°C pendant une durée de l'ordre de 10 heures.

L'insert gélifié est ensuite éventuellement dépoli.

Enfin, on procède au surmoulage : de manière classique, les blocs prémoulés sont fixés à leur place définitive, ainsi que le composant. On coule ensuite une résine époxy telle qu'une résine DGEBA avec un durcisseur par exemple anhydride du type DDSA (anhydride dodécényl-succinique), un accélérateur tel qu'un BDMA et une charge telle que de la silice.

La polymérisation de cette résine (qui deviendra une résine semi-dure) est obtenue par un passage à une température d'environ 125°C pendant une durée de l'ordre de 4 heures. On notera que ce chauffage final provoque également la polymérisation complète de la résine dure du bloc prémoulé.

Exemple II

On souhaite maintenant surmouler le composant dans une résine silicone.

L'insert est tout d'abord prémoulé dans une résine dure époxy identique à celle utilisée dans l'exemple précédent.

Le bloc prémoulé est ensuite dépoli et nettoyé, et on lui applique un enduit primaire d'adhérence tel qu'un "primer" MB de Rhône-Poulenc.

Le surmoulage est ensuite réalisé dans une résine silicone telle qu'une résine de la famille RTV (Room Temperature Vulcanization : vulcanisation à température ambiante) de Rhône-Poulenc, les résines de cette famille étant toutes des résines souples.

Sur les figures 4 à 6, on a représenté un exemple de composant réalisé suivant les enseignements de l'invention.

Le composant électronique proprement dit 10 est par exemple un condensateur très haute tension utilisé dans les matériels aéronautiques.

On sait que ces matériels aéronautiques sont soumis à des cycles thermiques répétés et très sévères (couramment entre -55°C et + 125°C), concurremment avec des vibrations intenses. La fixation des composants et leur protection à l'encontre des contraintes mécaniques et thermiques est donc une question critique, et l'invention apporte à cet égard des avantages décisifs.

A cet effet, selon un mode de réalisation avantageux, on relie ensemble les blocs 60 de résine dure emprisonnant les inserts 30 (ces blocs étant réalisés comme décrit précédemment) au moyen d'entretoises en une matière à faible coefficient de dilatation, telle qu'une résine époxy chargée de fibres de verre.

Ces entretoises relient par exemple six blocs 60, correspondant à six points de fixation du composant à son support, en deux groupes de trois blocs alignés (comme représenté figure 6). On prévoit par exemple (figure 4) une barrette commune 70a reliant les trois blocs à leur partie supérieure, et deux barrettes 70b, 70c à mi-hauteur des blocs. D'autres dispositions ou formes de charges peuvent également être envisagées, par exemple des charges en forme de tiges ou de plaques alvéolaires.

La fixation des barrettes aux blocs est effectuée de préférence par collage au moyen d'une colle époxy, ce qui assure une très bonne homogénéité des matériaux employés, qui sont tous à base de résines époxy. ·

Après réunion des blocs en résine dure au moyen des entretoises, on procède au coulage de la résine souple 20 de façon à surmouler l'ensemble comme indiqué plus haut. A cet effet, les entretoises peuvent comporter des alvéoles 80 améliorant l'accrochage avec la résine souple.

Les seuls éléments qui restent apparents sont, comme on peut le voir sur les figures, les six inserts de fixation 30 et les deux bornes de liaison 11 et 12 assurant la prise de connexion aux électrodes du composant proprement dit 10.

De préférence, on donne à la partie inférieure du bloc la forme de deux pieds longitudinaux 21, 22 parallèles aux charges de la partie inférieure du bloc, c'est-à-dire orientés comme les deux groupes d'inserts reliés ensemble par les entretoises. Ces pieds permettent de diminuer la masse de résine employée, et donc la masse finale du composant surmoulé.

En outre, ils permettent d'absorber les dilatations transversales du support, du fait de la souplesse de la résine d'enrobage.

On charge ainsi la partie inférieure du bloc de résine souple, grâce aux entretoises ancrées aux blocs de résine dure. Ceci permet, comme annoncé plus haut, de donner à cette partie inférieure un coefficient de dilatation faible, correspondant à celui des entretoises, et voisin de celui de la plaque métallique 40 sur laquelle est vissé le composant : ces coefficients sont de l'ordre de 10 à 20 ppm/°C (verre époxy) et 15 à 25 ppm/°C (métaux), respectivement, alors que les résines d'enrobage souples ont des coefficients de l'ordre de 100 à 200 ppm/°C.

Par ce moyen, la dilatation se répartit sur toute la hauteur du bloc au lieu de se localiser au droit des points de fixation, dont l'entraxe $x$ est imposé par l'entraxe des trous de fixation dans le support métallique 40, sans possibilité de jeu à ce niveau.

Le composant ainsi réalisé s'est avéré présenter une excellente tenue aux contraintes thermiques, même dans l'environnement difficile propre aux matériels aéronautiques embarqués où les vibrations et les efforts d'arrachement sont intenses.

REVENDICATIONS

1. Un composant (10) électrique ou électronique, surmoulé dans un bloc (20) de résine souple ou semi-dure emprisonnant des inserts (30) métalliques affleurant une surface de ce bloc pour permettre sa fixation à un support (40) extérieur, caractérisé en ce que chaque insert est lui-même emprisonné dans un bloc (60) en résine dure, ce dernier étant surmoulé avec le composant dans le bloc de résine souple ou semi-dure.

2. Un composant selon la revendication 1, caractérisé en ce que le bloc en résine dure est un bloc cylindrique, sensiblement coaxial avec l'insert métallique qu'il emprisonne.

3. Un composant selon l'une quelconque des revendications 1 et 2, caractérisé en ce que l'insert métallique comprend, au moins sur une partie de sa hauteur, une partie (32) de section polygonale.

4. Un composant selon la revendication 3, caractérisé en ce que les arêtes (33) de la partie de section polygonale sont abattues (34).

5. Un composant selon l'une quelconque des revendications 1 à 4, caractérisé en ce que la hauteur du bloc en résine dure est au moins double de celle de l'insert métallique.

6. Un composant selon l'une quelconque des revendications 1 à 5, comprenant une pluralité d'inserts (30a-30d) emprisonnés chacun dans un bloc respectif en résine dure, caractérisé en ce qu'au moins certains des blocs de résine dure sont solidarisés ensemble par au moins une entretoise rigide.

7. Un composant selon la revendication 6, caractérisé en ce que le matériau constituant les entretoises rigides est une résine époxy chargée de fibres

de verre.

8. Un composant selon la revendication 7, caractérisé en ce que les entretoises et les blocs de résine dure sont assemblés ensemble par collage au moyen d'une colle époxy.

9. Un procédé pour surmouler, dans un bloc de résine souple ou semi-dure, un composant électrique ou électronique ainsi que des inserts métalliques de fixation, caractérisé en ce qu'il comprend, avant l'étape de surmoulage du composant et des inserts, une étape de prémoulage de chaque insert dans un bloc de résine dure.

10. Un procédé selon la revendication 9, où la résine souple ou semi-dure ainsi que la résine dure sont des résines époxy, caractérisé en ce qu'il comprend, après prémoulage de l'insert mais avant surmoulage, une étape de gélification du bloc prémoulé, le durcissement final de ce dernier étant réalisé en même temps que celui du bloc surmoulé.

11. Un procédé selon la revendication 10, caractérisé en ce qu'il comprend, après gélification mais avant surmoulage, une étape de dépolissage du bloc prémoulé.

12. Un procédé selon la revendication 9, où la résine souple ou semi-dure est une résine silicone et où la résine dure est une résine époxy, caractérisé en ce qu'il comprend, après prémoulage de l'insert et durcissement de la résine dure mais avant surmoulage, une étape d'application, sur l'insert prémoulé, d'un enduit primaire d'adhérence.

13. Un procédé selon la revendication 12, caractérisé en ce qu'il comprend, après prémoulage de l'insert et durcissement de la résine dure mais avant application de l'enduit primaire d'adhérence, une étape de dépolissage du bloc prémoulé.

FIG_1

20

10

60

30

40

50

FIG_2

30

34

32

31

34

33

30

FIG_3

FIG.4

FIG.5

FIG.6

**Office européen des brevets**

**RAPPORT DE RECHERCHE EUROPEENNE**

**0123625**
Numéro de la demande

EP  84 40 0821

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. ³) |
|---|---|---|---|
| Y | DE-A-2 210 693  (DAIMLER-BENZ AG)<br>* En entier *<br><br>--- | 1,2,6 | H 05 K    5/06<br>B 29 C    6/00 |
| Y | FR-E-   68 944  (J.M. LEFEBVRE)<br><br>* En entier *<br><br>--- | 1,2,4, 9 | |
| A | DE-A-1 171 038  (SIEMENS & HALSKE AG)<br>* En entier *<br><br>--- | 1,2,6, 9,12 | |
| A | US-A-3 445 559  (D.C. SITEMAN)<br>* En entier *<br><br>--- | 1,2,9 | |
| A | DE-A-2 825 097  (K. KURZ HESSENTAL KG)<br>* En entier *<br><br>----- | 1,2,9 | **DOMAINES TECHNIQUES RECHERCHES (Int. Cl. ³)**<br><br>H 05 K<br>B 29 C |

Le présent rapport de recherche a été établi pour toutes les revendications

| Lieu de la recherche<br>LA HAYE | Date d'achèvement de la recherche<br>02-07-1984 | Examinateur<br>VISENTIN A. |
|---|---|---|